# EUROPÄISCHE PATENTANMELDUNG

(11) **EP 4 783 398 A1**
(43) Veröffentlichungstag der Anmeldung: **29.07.2026**
(21) Anmeldenummer: 26151735.3
(22) Anmeldetag: 14.01.2026
(51) Int. Cl.: H02J 3/26

(54) **SYMMETRIERVORRICHTUNG UND VERFAHREN ZUR SYMMETRIERUNG EINES UNGEERDETEN STROMVERSORGUNGSSYSTEMS UND ERWEITERTES ISOLATIONSÜBERWACHUNGSGERÄT**

(30) Priorität: 24.01.2025 DE 102025102561
(71) Anmelder: Bender GmbH & Co. KG, 35305 Grünberg (DE)
(72) Erfinder: Reitz, Julian, 35305 Grünberg (DE)
(74) Vertreter: advotec.

(57) **Zusammenfassung**

Die Erfindung betrifft eine Symmetriervorrichtung (10) sowie ein Verfahren zur Symmetrierung eines ungeerdeten Stromversorgungssystems (2). Die Symmetriervorrichtung (10) ist mehrpolig zwischen die jeweiligen aktiven Leiter und Erdpotenzial (PE) geschaltet und umfasst jeweils eine Spannungsmesseinrichtung (12) zur Erfassung einer jeweiligen Leiter-Erde-Spannung (U_{L1-PE}, U_{L2-PE}), einen Mikrocontroller (14), der die Leiter-Erde-Spannungen (U_{L1-PE}, U_{L2-PE}) auswertet, für jeden aktiven Leiter (L1, L2) jeweils einen PFC-Controller (16), der eine Regelimpedanz so nachbildet, dass sich zwischen den aktiven Leitern (L1, L2) eine Spannungssymmetrie einstellt, weiter einen Zwischenkreis (18), der eine in den Regelimpedanzen umgesetzte Energie speichert, und einen Umrichter (20), der die in dem Zwischenkreis (18) gespeicherte Energie an das Stromversorgungssystem (2) abgibt.

## Beschreibung

Die Erfindung betrifft eine Symmetriervorrichtung und ein Verfahren zur Symmetrierung eines ungeerdeten Stromversorgungssystems mit mindestens zwei aktiven Leitern sowie ein erweitertes Isolationsüberwachungsgerät mit der erfindungsgemäßen Symmetriervorrichtung.

Bei erhöhten Anforderungen an die Betriebs-, Brand-und Berührungssicherheit elektrischer Anlagen kommt die Netzform eines ungeerdeten Stromversorgungssystems zum Einsatz, die auch als isoliertes Netz (frz. "Isolé Terre"-IT) oder als IT-Stromversorgungssystem bezeichnet wird. Bei dieser Art des Stromversorgungssystems sind die aktiven Teile des Stromversorgungssystems von dem Erdpotential - gegen Erde - getrennt. Die Körper der angeschlossenen elektrischen Verbraucher sind einzeln oder gemeinsam geerdet. Der Vorteil dieser Netze liegt darin, dass bei einem ersten Isolationsfehler die Funktion der angeschlossenen elektrischen Verbraucher nicht beeinträchtigt wird und somit trotz des fehlerhaften Zustands der Isolierung ein Weiterbetrieb möglich ist, da sich wegen des im Idealfall unendlich großen elektrischen Widerstands (Isolationswiderstand) zwischen dem jeweiligen aktiven Leiter des Netzes und Erdpotential kein geschlossener Stromkreis ausbilden kann.

Zur Gewährleistung der elektrischen Sicherheit in ungeerdeten Stromversorgungssystemen werden gemäß der Norm IEC 61557-8 Isolationsüberwachungsgeräte (IMDs) verwendet. Diese sind in der Lage, kritische Anlagenzustände, wie ein zu niedriges Isolationsniveau oder zu hohe Erdkapazitätswerte, zu erkennen und zu melden. Gegebenenfalls wird nach einer Alarmmeldung des IMDs auch ein fehlerhafter Zweig abgeschaltet.

Ebenso kann die Symmetrie der Netzspannung in Bezug zum Erdpotential (Leiter-Erde-Spannung) als Überwachungs- und Meldegröße verwendet werden. Die Symmetrie der Leiter-Erde-Spannungen spielt neben dem Isolationswiderstand eine herausragende Rolle. Gemäß der Gleichung E=½CU² steigt die Energiemenge, welche in einer (Erd-)Ableitkapazität Cₑ gespeichert ist, mit der anliegenden Spannung quadratisch an. Liegt eine vollständige Spannungsasymmetrie der aktiven Leiter gegen Erde bei gleichbleibender Betriebsspannung vor, so steigt die Energiemenge in den Kapazitäten insgesamt um das Doppelte an. Gepaart mit einer simultanen Verdopplung der Leiter-Erde-Spannung kann für Menschen und Sachwerte eine deutlich erhöhte Gefährdung bei Berührung aktiver Leiter bestehen.

Um die im System gespeicherte Energie in Grenzen zu halten, besteht die Möglichkeit, die Ableitkapazitäten zu reduzieren oder nach einem Worst-Case Szenario zu dimensionieren. Dies ist jedoch je nach Ausdehnung des Stromversorgungssystems nicht immer möglich. Besonders relevant zeigt sich das Problem der Energieerhöhung in Kapazitäten bei asymmetrischen Leiter-Erde-Spannungen in ungeerdeten Gleichspannungsnetzen (DC-Netz). Hier können bereits hochohmige Asymmetrien der Isolationsniveaus der aktiven Leiter gegen Erde zu deutlichen Spannungsverschiebungen und damit verbundenen Energieerhöhungen führen. In Wechselspannungsnetzen (AC-Netz) verhalten sich Kapazitäten nicht nur als Speicher, sondern wirken als Blindwiderstand (Reaktanz). In vielen Fällen, besonders in ausgedehnten Industrienetzen, ist die Reaktanz der Ableitimpedanz niederohmiger als der Wirkwiderstand. So kann auch eine unsymmetrische Anordnung von Erdableitkapazitäten zu relevanten Spannungsverschiebungen und damit zu gefährlichen Spannungsüberhöhungen führen.

Bei einer Spannungsasymmetrie im AC-Netz ist aufgrund der Wechselspannung nicht die gespeicherte Energie, sondern die spannungsabhängige Belastung des Isolierungsmaterials und der EMV-Schutzbeschaltungen von größerer Bedeutung. Solche Komponenten erfahren bei dauerhaften Spannungsasymmetrien einseitig stärkere Abnutzungen und können in ihrer Lebensdauer beeinträchtigt sein.

Eine Begrenzung der Erdableitkapazität ist sowohl in AC- als auch in DC-Netzen vorteilhaft, jedoch technisch nicht immer durchführbar.

Alternativ und aufgrund der quadratischen Abhängigkeit deutlich effizienter ist eine aktive oder passive Symmetrierung der Leiter-Erde-Spannungen.

Unabhängig von der detaillierten Ausführung ist die Symmetrierung in der Regel mit Energieaufwendung verbunden. Dies bedeutet, dass entweder auf der Seite der Spannungsüberhöhung Energie, beispielsweise mittels ohmscher Widerstände, entnommen - in Wärme umgewandelt - wird oder dass auf anderer Seite Energie in Form einer Stromquelle zugeführt wird. Insbesondere bei ungeerdeten Wechselspannungsnetzen mit niedrigen Ableitimpedanzen können Blindleistungen bis in den kVA-Bereich erforderlich sein, um die Symmetrierung herbeizuführen.

Eine aktive Methode zur Spannungssymmetrierung mit neutraler Energiebilanz ist Gegenstand der hier beschriebenen Erfindung.

Nach dem Stand der Technik wird die Energiebegrenzung von Erdableitkapazitäten in ungeerdeten Stromnetzen durch anwendungsspezifische Vorgaben zur Größe des zulässigen Kapazitätswertes bewerkstelligt.

Häufig lassen sich aber aufgrund physikalischer Systemeigenschaften, wie beispielsweise bei PV-Anlagen, keine Eingrenzungen vornehmen.

Bekannterweise kann ferner die Leiter-Erde-Spannung aktiv oder passiv symmetriert werden. Als passive Lösung bietet sich hierzu ein symmetrischer Spannungsteiler mit Erdpotential in Mittelanzapfung an. Da diese Widerstände, welche permanent im System verbleiben, nicht hinreichend niederohmig gestaltet werden können, stellt diese Methode nur eine begrenzte Lösung für asymmetrische Absenkungen des Isolationswiderstands dar. Bekannte IMDs erfüllen bereits durch ihren technischen Aufbau mit symmetrischer Netzankopplung diese Eigenschaft.

Aktive Verfahren können die Spannungsasymmetrie auswerten und entsprechend darauf reagieren.

Die Offenlegungsschrift DE 10 2020 006 919 A1 zeigt ein derartiges Verfahren zum Ermitteln einer Schieflast, wobei zum Ausgleich etwaiger Spannungsschieflasten diskrete Widerstandswerte zwischen die aktiven Leiter und Erde zu- oder abgeschaltet werden.

Auch mit Spannungs- und Stromquellenschaltungen ist eine aktive Schieflast-Korrektur denkbar. Eine solche Ausgestaltung innerhalb eines erweiterten Isolationsüberwachungsgerätes wird in der Offenlegung WO 2023/007253 A1 aufgezeigt.

Die Patentschrift DE 10 2018 116 055 B3 beschreibt weiter ein Verfahren und Isolationswächter zur widerstandsadaptiven Isolierungsüberwachung. Es wird ein klassisches 3-VoltmeterVerfahren beschrieben, bei welchem zwei Arbeitspunkte betrachtet werden. Jedoch werden hier keine diskreten Widerstände umgeschaltet, sondern es wird eine Kombination aus Halbleiterschalter und Widerstand zu einem, über eine gewisse Integrationszeit beständigen, Ankoppelwiderstand moduliert.

In der Offenlegungsschrift DE 10 2020 211 760 A1 wird eine Anordnung von Symmetrierwiderständen gezeigt, welche gleichzeitig zur Entladung von Entstörkondensatoren genutzt werden.

Sämtliche vorgenannten Verfahren betreffen ungeerdete Gleichstrom-Stromversorgungssysteme. Für ungeerdete Wechselspannungs-Stromversorgungssysteme sind aus dem Stand der Technik keine Verfahren und Vorrichtungen zur Symmetrierung bekannt, insbesondere auch keine Maßnahmen, welche mit neutraler Energiebilanz eine Symmetrierung herbeiführen.

Der vorliegenden Erfindung liegt somit die Aufgabe zugrunde, eine elektrische Schaltungsvorrichtung und ein Verfahren zu konzipieren, mit welchen in einem ungeerdeten Stromversorgungssystem, insbesondere in einem ungeerdeten Wechselspannungs-Stromversorgungssystem, eine Symmetrierung der Leiter-Erde-Spannungen möglichst energieneutral - unter Minimierung der Verlustleistung - erreicht werden soll.

Diese Aufgabe wird gelöst durch eine Symmetriervorrichtung, die mehrpolig zwischen die jeweiligen aktiven Leiter und Erdpotential geschaltet ist und die Merkmale gemäß Anspruch 1 aufweist.

Die Symmetriervorrichtung umfasst eine Spannungsmesseinrichtung, welche an jedem aktiven Leiter die gegen Erde auftretende jeweilige Leiter-Erde-Spannung erfasst. Ein Mikrocontroller wertet die gemessenen Leiter-Erde-Spannungen aus und steuert einen für jeden aktiven Leiter jeweils installierten PFC-Controller (Power-Factor-Correction Controller) an, wobei die zum Erreichen der Symmetrie erforderlichen Leiter-Erde-Spannungen von dem Mikrocontroller als Sollwerte vorgegeben werden. Der jeweilige PFC-Controller regelt die Stromaufnahme so, dass für jeden aktiven Leiter individuell eine Regelimpedanz nachgebildet wird, deren Größe über die Bereitstellung von Blindleistung zu der gewünschten Symmetrierung der Leiter-Erde-Spannungen führt. Die Symmetriervorrichtung verfügt weiter über einen Zwischenkreis, um die in den Regelimpedanzen umgesetzte Energie zu speichern sowie über einen Umrichter, der die in dem Zwischenkreis gespeicherte Energie mit einer an das Stromversorgungssystem angepassten Frequenz an dieses abgibt.

Die Symmetriervorrichtung ist damit in der Lage, der Spannungsüberhöhung einer Leiter-Erde-Spannung mit einer Belastung in Form einer Regelimpedanz zu begegnen. Entgegen klassischer Methoden zur Spannungssymmetrierung mit (steuerbaren) Symmetrierwiderständen wird die Energie, die in der nachgebildeten Regelimpedanz umgesetzt wird, nicht in Wärme (Verlustleistung) gewandelt, sondern als elektrische Energie zwischen den aktiven Leitern in das Stromversorgungssystem zurückgespeist.

Die gezeigte Symmetriervorrichtung ist so ausgeführt, dass eine weitgehend neutrale Energiebilanz in Bezug zu dem zu symmetrierenden, ungeerdeten Stromversorgungssystem erreicht wird, also weder Energie entnommen und thermisch verwertet, noch Energie zugeführt werden muss, um die Symmetrieraufgabe zu erfüllen.

In weiterer Ausgestaltung weist die Symmetriervorrichtung eine Datenleitung zwischen der Symmetriervorrichtung und einem Isolationsüberwachungsgerät auf, auf welcher Informationen über die eingestellten Regelimpedanzen an das Isolationsüberwachungsgerät übermittelt werden.

Die Symmetriervorrichtung bringt Regelimpedanzen in das Stromversorgungssystem ein, welche von einem unabhängigen IMD gemessen und angezeigt werden. Unweigerlich würde das zu falschen Interpretationen des Anlagenzustands führen, weshalb der Anzeigewert des IMD korrigiert wird. Dazu werden dem IMD mittels der Datenleitung Informationen über die eingestellten Regelimpedanzen von der Symmetriervorrichtung übermittelt und mittels bekannter Strom-Spannungsbeziehungen (Parallelschaltung von Widerständen) herausgerechnet.

Die der Erfindung zugrundeliegende Aufgabe wird weiter durch ein erweitertes Isolationsüberwachungsgerät gelöst, welches die erfindungsgemäße Symmetrievorrichtung integriert und mit diesem eine bauliche Einheit ausbildet.

Ein in dieser Form erweitertes, vornehmlich normgemäßes, Isolationsüberwachungsgerät erfüllt somit neben der Isolationsüberwachung gleichzeitig die Funktion der Symmetrierung des überwachten ungeerdeten Stromversorgungssystems. In vorteilhafter Weise werden elektrische (z. B. Netzteil) und bauliche (z. B. Gehäuse) Ressourcen gemeinsam und kosteneffizient genutzt.

Die zuvor beschriebene erfindungsgemäße Symmetriervorrichtung beruht auf der Umsetzung eines erfindungsgemäßen Verfahrens. Insoweit spiegeln sich die vorgenannten technischen Wirkungen auch in den verfahrenstechnischen Vorteilen der Verfahrensmerkmale wider.

Insbesondere zeichnet sich das Verfahren durch eine elektrisch nahezu verlustfreie Symmetrierung aus.

Weiter kann die Symmetriervorrichtung dazu genutzt werden, die Funktionsfähigkeit des Isolationsüberwachungsgeräts zu überprüfen.

Anwender können mit Hilfe der Symmetriervorrichtung (Rege1-)Impedanzen in das Stromversorgungssystem einprägen und so verschiedenste Anlagenszenarien und die Reaktion des Isolationsüberwachungsgeräts simulieren.

Auch ist es möglich, die Symmetriervorrichtung zur Erzeugung von Gleichtaktströmen zu nutzen, welche für die Fehlersuche mittels Isolationsfehlersuchsystemen (IFLS) in ungeerdeten Stromversorgungssystemen von Bedeutung sind.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1:**: ein ungeerdetes einphasiges Stromversorgungssystem mit einer erfindungsgemäßen Symmetriervorrichtung,
- **Fig. 2:**: die erfindungsgemäße Symmetriervorrichtung in funktionaler Darstellung und
- **Fig. 3:**: das ungeerdete einphasige Stromversorgungssystem mit der erfindungsgemäßen Symmetriervorrichtung und Datenleitung zu einem Isolationsüberwachungsgerät.

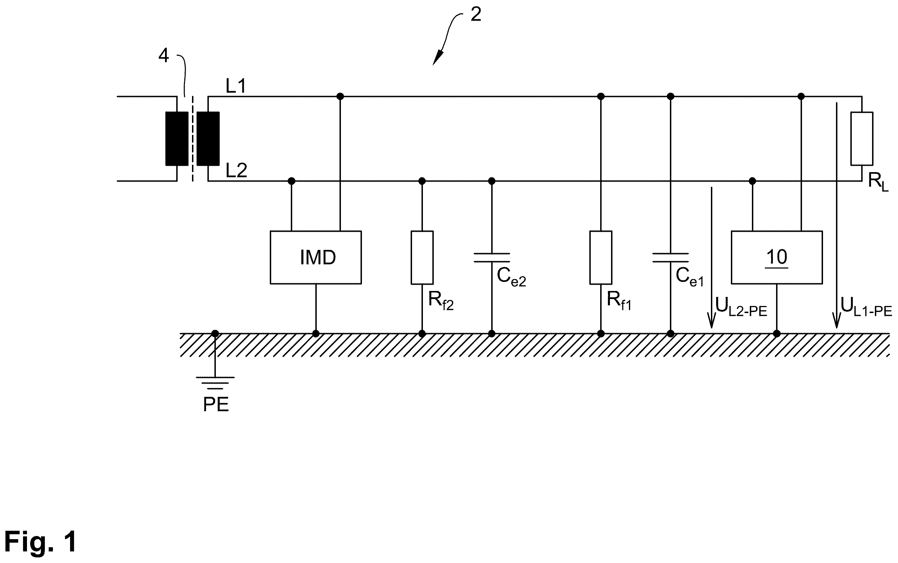

**Fig. 1** zeigt ein ungeerdetes einphasiges Stromversorgungssystem 2 mit einer erfindungsgemäßen Symmetriervorrichtung 10.

Das Stromversorgungssystem 2 ist beispielhaft als einphasiges Wechselspannungsnetz mit den aktiven Leitern L1, L2 ausgebildet und wird durch den Trenntransformator 4 gespeist.

Isolationswiderstände R_{f1}, R_{f2} und Ableitkapazitäten Cₑ₁ und Cₑ₂ ergeben komplexwertige Ableitimpedanzen gegen Erde (Erdpotenzial PE). Als Verbraucher ist ein Lastwiderstand R_{L} an das Stromversorgungssystem 2 angeschlossen.

Eine erfindungsgemäße Symmetriervorrichtung 10 ist mehrpolig zwischen die jeweiligen aktiven Leiter L1, L2 und Erdpotenzial PE geschaltet.

Der Gesamtisolationswiderstand, der sich hier aus der Parallelschaltung der Isolationswiderstände R_{f1}, R_{f2} ergibt, wird von einem Isolationsüberwachungsgerät IMD bestimmt, welches ebenfalls mehrpolig zwischen die jeweiligen aktiven Leiter L1, L2 und Erdpotenzial PE angeschlossen ist.

Das Stromversorgungssystem 2 und das (nicht erweiterte) Isolationsüberwachungsgerät IMD stellen eine Anwendungsumgebung für die vorliegende Erfindung dar und sind nicht Bestandteil der Erfindung.

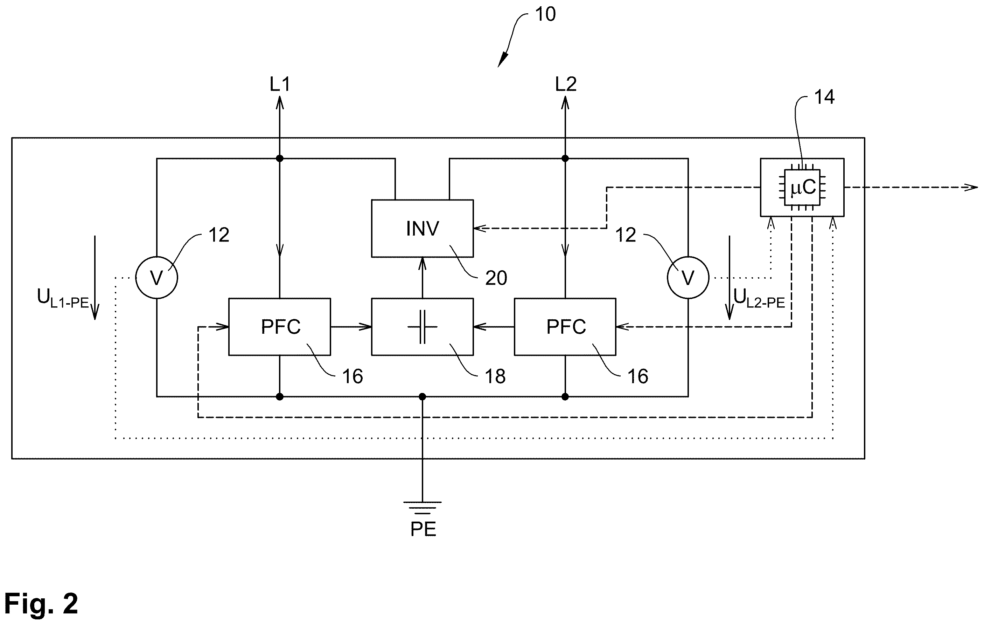

**Fig. 2** zeigt die erfindungsgemäße Symmetriervorrichtung 10 als funktionales Blockschaltbild.

Leiter-Erde-Spannungen U_{L1-PE}, U_{L2-PE} werden individuell für jeden aktiven Leiter L1, L2 mit Spannungsmesseinrichtungen 12 erfasst und zur Auswertung einem Mikrocontroller 14 zugeführt. Mit den jeweiligen Leiter-Erde-Spannungen U_{L1-PE}, U_{L2-PE} als Sollwerte steuert der Mikrocontroller 14 einen für jeden aktiven Leiter L1, L2 jeweils installierten PFC-Controller 16 an. Die PFC-Controller 16 wirken als Stellglieder in einem Regelkreis und bilden das Kernelement der Symmetriervorrichtung 10.

Die aus dem Anwendungsbereich der Netzteile bekannten PFC-Controller 16 arbeiten jeweils als Energiesenke und bilden die für die Symmetrierung notwendigen Regelimpedanzen ab. PFC-Controller 16 sind aktive leistungselektronische Schaltungsgruppen, welche insbesondere bei Verbrauchern zum Einsatz kommen, welche eine nichtlineare Leistungsaufnahme haben. Dabei regeln PFC-Controller 16 die Stromaufnahme so, dass ein ohmsches Verhalten mit sinusförmiger Stromaufnahme bei sinusförmiger Spannung hergestellt wird. Grundsätzlich kann daher ein PFC-Controller 16 als Schaltungsgruppe zur geregelten Bereitstellung einer Regelimpedanz betrachtet werden. Dieses Verhalten ist hier notwendig, um (Regel-)Impedanzen aus Wirkwiderstand und Reaktanz nachzubilden.

Ein Zwischenkreis 18 nimmt die Energie im Falle des Wirkwiderstands auf oder stellt sie für die Nutzung der PFC-Controller 16 als Blindwiderstand bereit.

Ein Umrichter 20 gibt die Energie aus dem Zwischenkreis 18 in das Stromversorgungssystem 2 ab.

Bei Notwendigkeit kann auch Energie aus dem Umrichter in den Zwischenkreis zugeführt werden.

Alle vorgesehenen leistungselektronischen Baugruppen können als nahezu verlustfrei angesehen werden.

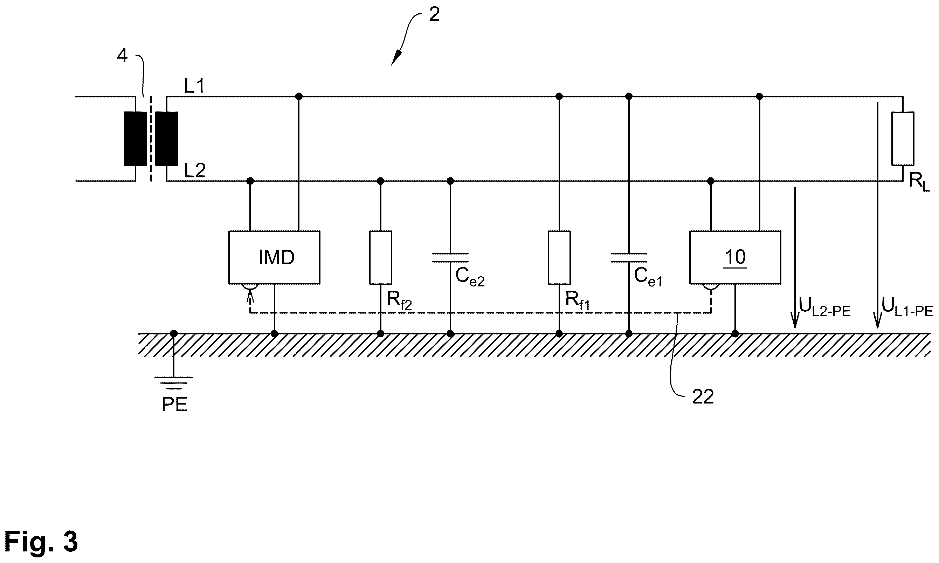

In **Fig. 3** ist ergänzend zu Fig. 1 das ungeerdete einphasige Stromversorgungssystem 2 mit der erfindungsgemäßen Symmetriervorrichtung 10 und einer Datenleitung 22 zu dem Isolationsüberwachungsgerät IMD dargestellt.

Über die Datenleitung 22 erlangt das Isolationsüberwachungsgerät IMD Kenntnis von den Regelimpedanzen, die von der Symmetriervorrichtung 10 leiterspezifisch eingebracht werden. Da diese Regelimpedanzen das Messergebnis des Isolationsüberwachungsgerätes IMD beeinflussen, werden sie in dem Isolationsüberwachungsgerät IMD bei der Bestimmung des Isolationswiderstands berücksichtigt. Damit wird eine aktive und situative Symmetrierung ermöglicht, ohne dass das Isolationsüberwachungsgerät IMD fehlerbehaftete Messergebnisse anzeigt.

Grundsätzlich ist für ein dreiphasiges Wechselspannungsnetz auch eine der erfindungsgemäßen Symmetriervorrichtung 10 entsprechende dreiphasig ausgeführte und angekoppelte Symmetriervorrichtung möglich.

Auch kann die Symmetriervorrichtung 10 sowohl in ungeerdeten AC- als auch in DC- Stromversorgungssystemen 2 genutzt werden.

## Patentansprüche

1. Symmetriervorrichtung (10) zur Symmetrierung eines ungeerdeten Stromversorgungssystems (2) mit mindestens zwei aktiven Leitern (L1, L2),
wobei die Symmetriervorrichtung (10) mehrpolig zwischen die jeweiligen aktiven Leiter und Erdpotenzial (PE) geschaltet ist, umfassend jeweils eine Spannungsmesseinrichtung (12) zur Erfassung einer jeweiligen Leiter-Erde-Spannung (U_{L1-PE}, U_{L2-PE}), einen Mikrocontroller (14), der die Leiter-Erde-Spannungen (U_{L1-PE}, U_{L2-PE}) auswertet, für jeden aktiven Leiter (L1, L2) jeweils einen von dem Mikrocontroller (14) unter Vorgabe symmetrischer Leiter-Erde-Spannungen (U_{L1-PE}, U_{L2-PE}) als Sollwerte angesteuerten PFC-Controller (16), der für jeden aktiven Leiter (L1, L2) eine Regelimpedanz so nachbildet, dass sich zwischen den aktiven Leitern (L1, L2) eine Spannungssymmetrie einstellt, einen Zwischenkreis (18), der eine in den Regelimpedanzen umgesetzte Energie speichert, und einen Umrichter (20), der die in dem Zwischenkreis (18) gespeicherte Energie an das Stromversorgungssystem (2) abgibt.

2. Symmetriervorrichtung (10) nach Anspruch 1,
**gekennzeichnet durch**
eine Datenleitung (22) zwischen der Symmetriervorrichtung (10) und
einem Isolationsüberwachungsgerät (IMD), auf welcher Informationen über die eingestellten Regelimpedanzen an das Isolationsüberwachungsgerät (IMD) übermittelt werden.

3. Erweitertes Isolationsüberwachungsgerät,
**gekennzeichnet durch**
eine integrierte Symmetriervorrichtung (10) nach Anspruch 1 oder 2 zur Ausbildung einer baulichen Einheit.

4. Verfahren zur Symmetrierung eines ungeerdeten Stromversorgungssystems (2) mit mindestens zwei aktiven Leitern (L1, L2), umfassend die in einer mehrpolig zwischen die jeweiligen aktiven Leiter (L1, L2) und Erdpotenzial (PE) geschalteten Symmetriervorrichtung (10) auszuführenden Verfahrensschritte:
Erfassen einer jeweiligen Leiter-Erde-Spannung (U_{L1-PE}, U_{L2-PE}) mittels einer Spannungsmesseinrichtung (12),
Auswerten der Leiter-Erde-Spannungen (U_{L1-PE}, U_{L2-PE}) mittels eines Mikrokontrollers (14),
Vorgeben symmetrischer Leiter-Erde-Spannungen (U_{L1-PE}, U_{L2-PE}) als Sollwerte an jeweils einen für jeden Leiter (L1, L2) von dem Mikrokontroller (14) angesteuerten PFC-Controller (16),
Nachbilden einer Regelimpedanz mittels des jeweiligen PFC-Controllers (16) für jeden aktiven Leiter (L1, L2) so, dass sich zwischen den aktiven Leitern (L1, L2) eine Spannungssymmetrie einstellt,
Speichern einer in den Regelimpedanzen umgesetzten Energie in einem Zwischenkreis (18) und
Abgeben der in dem Zwischenkreis (18) gespeicherten Energie an das Stromversorgungssystem (2) mittels eines Umrichters (20).

5. Verfahren nach Anspruch 4,
**gekennzeichnet durch**
Übermitteln von Informationen über die eingestellten Regelimpedanzen an ein Isolationsüberwachungsgerät (IMD) mittels einer Datenleitung (22) zwischen der Symmetriervorrichtung (10) und dem Isolationsüberwachungsgerät (IMD).

6. Verwendung der Symmetriervorrichtung (10) nach Anspruch 1 oder 2 zum Überprüfen der Funktionsfähigkeit eines Isolationsüberwachungsgeräts (IMD).

7. Verwendung der Symmetriervorrichtung (10) nach Anspruch 1 oder 2 zum Erzeugen von Gleichtaktströmen für eine Fehlersuche mittels Isolationsfehlersuchsystemen in einem ungeerdeten Stromversorgungssystem (2).
